# EUROPEAN PATENT SPECIFICATION

(11) **EP 2 838 332 B1**
(45) Date of publication and mention of the grant of the patent: **21.09.2016**
(21) Application number: 12874200.4
(22) Date of filing: 09.04.2012
(51) Int. Cl.: H05K 13/00, H05K 13/04

(54) **MOUNTING HEAD CLEANING DEVICE**
REINIGUNGSVORRICHTUNG FÜR MONTAGEKOPF
DISPOSITIF DE NETTOYAGE DE TÊTE DE MONTAGE

(43) Date of publication of application: 18.02.2015
(73) Proprietor: Fuji Machine Mfg. Co., Ltd., Chiryu-shi Aichi 472-8686 (JP)
(72) Inventor: SHIMOSAKA Kenji, Chiryu-shi Aichi 472-8686 (JP); HONDA Yoshiyuki, Chiryu-shi Aichi 472-8686 (JP)
(74) Representative: Grünecker Patent- und Rechtsanwälte PartG mbB
(86) International application number: PCT/JP2012/059684
(87) International publication number: WO 2013/153598

(56) References cited:
- WO-A1-03/092918
- JP-A- H10 305 253
- JP-A- 2001 320 159
- JP-A- 2004 071 975
- JP-A- 2011 003 679
- JP-A- 2011 003 679
- JP-A- 2012 005 948

## Description

### Technical Field

The present invention relates to a mounting head cleaning device that can clean an air passage formed in a mounting head including a rotary head and can check the performance of the mounting head after cleaning.

### Background Art

A component mounting machine including a rotary mounting head is provided with a rotary head that holds a plurality of suction nozzles on the circumference thereof so as to allow the suction nozzles to be movable, up and down, and can be indexed. In the component mounting machine including this kind of mounting head, negative-pressure air is sequentially introduced into air passages communicating with the plurality of suction nozzles to suck electronic components. However, since dust and the like are sucked into the air passages when the electronic components are sucked by the suction nozzles, it is necessary to regularly perform maintenance (cleaning) in the mounting head.

In the past, a device disclosed in, for example, PTL 1 has been known as a maintenance device. In the device disclosed in PTL 1, at the time of maintenance, a revolver head 11 is separated from a head holder 12 of a mounting head and the revolver head 11 is set on a pedestal 33 of the maintenance device. Further, a maintenance adapter 40 is mounted on the upper surface of the set revolver head 11 so that air passages formed in the revolver head 11 are connected to a maintenance liquid supply device 41, and the air passages communicating with a plurality of suction nozzles provided on the circumference of the revolver head 11 are cleaned in a manual operation.

### Citation List

### Patent Literature

PTL 1: JP-A-2011-3679

### Summary of Invention

### Technical Problem

However, the device disclosed in PTL 1 cleans the air passages communicating with the plurality of suction nozzles, which are provided on the circumference of the revolver head 11, in the manual operation. In addition, since the revolver head 11 is disassembled and separated from the mounting head of a component mounting machine and is set on the pedestal 33 of the maintenance device when maintenance is to be performed, maintenance work is cumbersome. For this reason, there is a problem in that a great deal of time is required for maintenance.

Moreover, the device disclosed in PTL 1 is only for cleaning the air passages formed in the revolver head 11, and does not have a function of checking the revolver head after cleaning. For this reason, there is a problem in that it is not possible to verify whether or not the cleaning of the air passages has been performed well.

The invention has been made to solve the above-mentioned problems, and an object of the invention is to provide a mounting head cleaning device in which a mounting head itself including a rotary head can be set on a cleaning unit and which not only can clean air passages formed in the mounting head but also can check the performance of the mounting head after cleaning.

### Solution to Problem

In order to solve the above-mentioned problems, the invention related to claim 1 is directed to a mounting head cleaning device that **comprises** a mounting head including suction nozzles sucking components, and **a cleaning unit on which the mounting head is detachably mounted and which is configured to clean** the inside of the mounting head by supplying air or oil mist to negative-pressure air passages formed in the mounting head, wherein the **cleaning unit** includes **an air supply source for supplying air, a passage for cleaning, and a passage for checking,** switching means for selectively supplying air, which is supplied from **the** air supply source, to **the** passage for cleaning or **the** passage for checking, introducing means for introducing air into the respective negative-pressure air passages, which are formed in the mounting head and are connected to the plurality of suction nozzles, from the passage for cleaning or the passage for checking that is selected by the switching means, and air measuring means provided in the passage for checking.

According to the above-mentioned structure, the mounting head itself is mounted on the cleaning unit and the negative-pressure air passages formed in the mounting head are cleaned. Accordingly, it is possible to automatically clean the inside of the mounting head by separating the mounting head from a component mounting machine and mounting the mounting head on the cleaning unit. Therefore, it is possible to simply perform cleaning work for a short period of time.

Further, according to the above-mentioned structure, it is possible to clean the negative-pressure air passages by the air introduced into the negative-pressure air passages, which are formed in the mounting head, from the passage for cleaning of the cleaning unit. Accordingly, it is possible to exclude dust and the like that are sucked into the negative-pressure air passages from the suction nozzles at the time of the suction of components and the like. Moreover, since the switching means is switched and air is introduced into the mounting head from the passage for checking of the cleaning unit after cleaning, it is possible to measure the flow of air, which flows in the passage for checking, by the air measuring means.

The invention related to claim **2** is directed to claim **1**, wherein the mounting head cleaning device further **comprises** an operation panel that displays a result of cleaning on the basis of information measured by the air measuring means.

According to the above-mentioned structure, it is possible to display the information, which is measured by the air measuring means provided in the passage for checking, on the operation panel.

The invention related to claim **3** is directed to claim **1** or **2**, wherein the air measuring means is formed of a flow rate measuring sensor that measures a flow rate of air flowing in the passage for checking.

According to the above-mentioned structure, it is possible to display information about the flow rate, which is measured by the flow rate measuring sensor provided in the passage for checking, on the operation panel and to display the result of cleaning, whether the mounting head is acceptable or not, which is based on the result of cleaning, and the like on the operation panel.

The invention related to claim **4** is directed to any one of claims **1** to **3**, wherein the passage for cleaning includes a cleaning air passage that supplies air and a cleaning oil passage that supplies oil mist, and **an air/oil cleaning switching valve for** the switching of the cleaning air passage and the cleaning oil passage **such that air or oil mist is supplied to the negative-pressure air passages.**

According to the above-mentioned structure, it is possible to selectively perform the cleaning of the negative-pressure air passage with air or oil, and to perform the effective cleaning of the mounting head by, for example, performing cleaning, which uses air, at regular time intervals and performing cleaning using oil per several times of cleaning using air.

The invention related to claim **5** is directed to any one of claims **1** to **4**, wherein the cleaning unit includes a dirt suction blower that sucks dirty air or oil discharged from the suction nozzles of the mounting head.

According to the above-mentioned structure, it is possible to prevent dirty air or oil, which is discharged from the suction nozzle by the cleaning of the negative-pressure air passage, from being scattered to the surroundings by the dirt suction blower.

The invention related to claim **6** is directed to any one of claims **2** to **5**, **wherein the mounting head cleaning device further comprises a controller for controlling the cleaning unit**, wherein the operation panel displays a selection screen for a cleaning mode used to clean the mounting head and a checking mode used to check the mounting head when the mounting head is mounted on the cleaning unit, and **wherein the controller is configured to perform** a cleaning cycle or a checking cycle **after** the selection of the cleaning mode or the checking mode.

According to the above-mentioned structure, after the mounting head is mounted on the cleaning unit, it is possible to select the cleaning mode or the checking mode and to easily perform the cleaning cycle or the checking cycle by operating the operation panel according to the selection screen displayed on the operation panel.

The invention related to claim **7** is directed to claim **6**, wherein lids are provided so that air is not discharged from the suction nozzles **during the checking cycle**.

According to the above-mentioned structure, the discharge of air from the suction nozzle can be prevented by the lid at the time of the checking cycle. Accordingly, it is possible to check the leakage or the like of air from a sliding portion of the nozzle shaft that holds the suction nozzle.

The invention related to claim **8** is directed to claim **7**, wherein a pressure sensor, which measures pressure of air present in the passage for checking, is connected to the passage for checking, and the operation panel displays the measured pressure of air and a result of determination of whether the mounting head is acceptable or not, which is based on the measured pressure of air **during** the checking cycle.

According to the above-mentioned structure, it is possible to check the leakage or the like of air from the sliding portion of the nozzle shaft, which holds the suction nozzle, by measuring the pressure of air with the pressure sensor and to display the result of the check on the operation panel.

The invention related to claim **9** is directed to claim **7**, wherein the mounting head includes a rotary head, which holds the plurality of suction nozzles sucking components on the circumference thereof and is capable of being indexed, **wherein the controller is configured to sequentially index** the rotary head, **to move up and down** each suction nozzle at each index position, **and to measure** upward and downward movement times of these suction nozzles **during air supply to the negative-pressure air passages**, and **wherein** the operation panel displays the measured upward and downward movement times and a result of determination of whether the mounting head is acceptable or not that is based on the measured upward and downward movement times.

According to the above-mentioned structure, it is possible not only to check the leakage or the like of air from the sliding portion of the nozzle shaft, which holds the suction nozzle sliding in the rotary head, a mechanical switching valve, which performs the switching between the supply and cut-off of negative-pressure air to the negative-pressure air passage, or the like, but also to measure the sliding resistance of the nozzle shaft, which holds the suction nozzle, by measuring the upward and downward movement times of the suction nozzle. Therefore, it is possible to check an abnormal state, such as the catching of dust or metal powder at the sliding portion.

### Brief Description of Drawings

[Fig. 1] Fig. 1 is a perspective view showing the entire component mounting machine to which a mounting head cleaning device of the invention is applied.
[Fig. 2] Fig. 2 is a view showing a rotary mounting head according to an embodiment of the invention.
[Fig. 3] Fig. 3 is a view showing a head clamping device that clamps the mounting head on an X-axis slide or a cleaning unit.
[Fig. 4] Fig. 4 is a cross-sectional view showing a state in which the mounting head is clamped on the X-axis slide or the cleaning unit.
[Fig. 5] Fig. 5 is a view showing a mechanical switching valve that opens and closes a negative-pressure air passage.
[Fig. 6] Fig. 6 is a view showing the cleaning unit that cleans the inside of the mounting head.
[Fig. 7] Fig. 7 is a view showing a fluid supply circuit that is provided in the cleaning unit.
[Fig. 8] Fig. 8 is a block diagram showing a controller that controls the cleaning unit.
[Fig. 9] Fig. 9 is a flowchart illustrating a cleaning cycle using air.
[Fig. 10] Fig. 10 is a flowchart illustrating a cleaning cycle using oil.
[Fig. 11] Fig. 11 is a flowchart illustrating a checking cycle after cleaning.

### Description of Embodiments

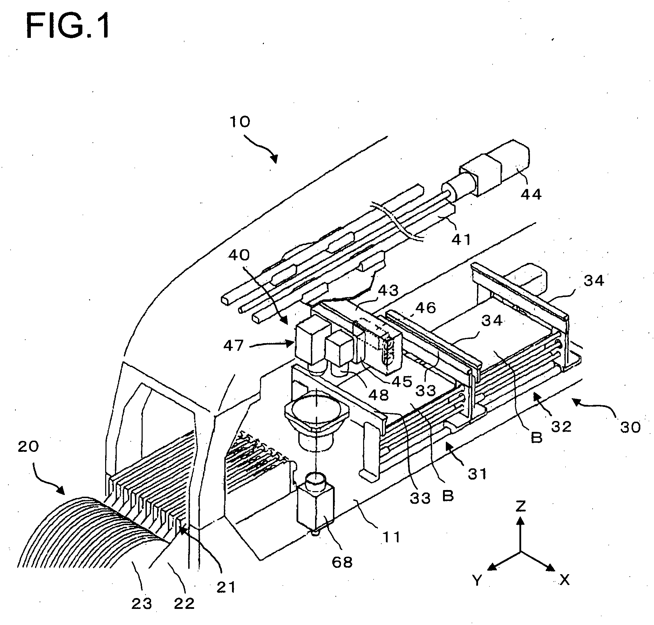

An embodiment of the invention will be described below with reference to the drawings. As shown in Fig. 1, a component mounting machine 10 includes a component supply device 20, a board conveying device 30, and a component transfer device 40.

For example, the component supply device 20 has a structure in which a plurality of cassette-type feeders 21 are arranged side by side on a base 11 in an X-axis direction. The feeder 21 is detachably mounted on a body frame 22 detachably mounted on the base 11, and includes a supply reel 23 on which a tape in which a plurality of electronic components are received in line at intervals is wound. Although not shown, a motor serving as a drive source, which allows the pitch-feed of a tape, is built in the feeder 21. The tape is fed by one pitch by the motor, so that the electronic components received in the tape are sequentially supplied to a component supply position provided at a tip portion of the feeder 21.

The board conveying device 30 conveys a circuit board B in the X-axis direction, and positions and holds the circuit board B at a predetermined position. For example, the board conveying device 30 has a double-conveyor structure in which conveying means 31 and 32 are arranged side by side in two lines. The respective conveying means 31 and 32 are horizontally arranged side by side on the base 11 so that a pair of guide rails 33 and a pair of guide rails 34 face each other in parallel to each other. A pair of conveyor belts (not shown), which support and convey the circuit boards B guided by the guide rails 33 and 34, are arranged side by side in the conveying means 31 and 32.

The component transfer device 40 is formed of an XY robot. The XY robot is mounted on the base 11 so as to be disposed above the component supply device 20 and the board conveying device 30, and includes a Y-axis slide 43 that can move along guide rails 41 in a Y-axis direction orthogonal to the X-axis direction. The movement of the Y-axis slide 43 in the Y-axis direction is controlled through a ball screw by a servo motor 44. An X-axis slide 45 is guided and supported by the Y-axis slide 43 so as to be movable in the X-axis direction, and the movement of the X-axis slide 45 in the X-axis direction is controlled through a ball screw by a servo motor 46.

As described in detail below, a mounting head 47, which includes a suction nozzle sucking an electronic component, is detachably mounted on the X-axis slide 45. Further, a board camera 48, which takes an image of a reference mark (not shown) of the circuit board B, is mounted on the X-axis slide 45.

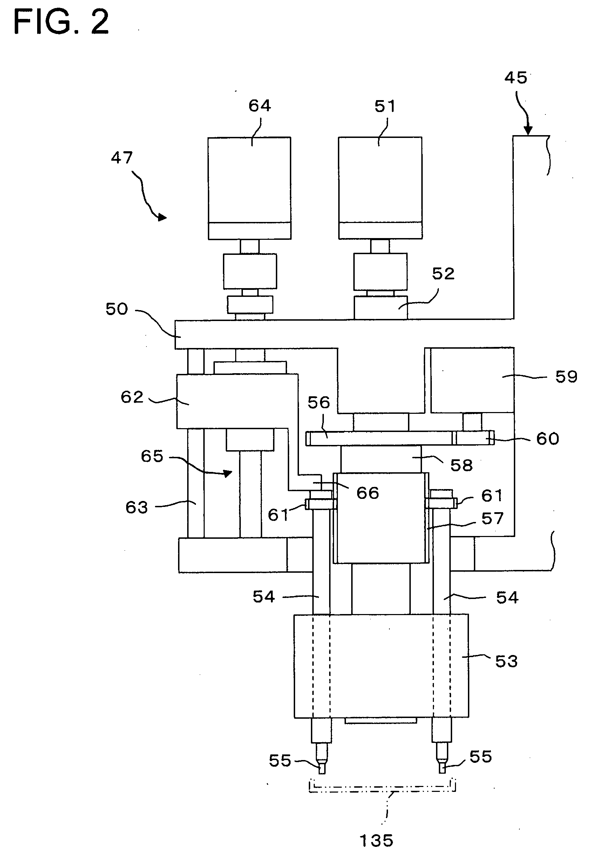

As shown in Fig. 2, the mounting head 47 includes a head body 50 that is detachably mounted on the X-axis slide 45. An index shaft 52, which is indexed by a predetermined angle by an R-axis motor 51, is rotatably supported by the head body 50, and a rotary head 53 is fixed to the lower end of the index shaft 52.

A plurality of (for example, twelve) nozzle shafts 54 are held on the circumference of the rotary head 53 so as to be movable, up and down, in a direction, which is parallel to a rotation axis of the rotary head 53, and is rotatable. The nozzle shaft 54 is generally held at an upper end position by the spring force of a spring (not shown). A suction nozzle 55, which sucks an electronic component, is detachably mounted at the tip of each nozzle shaft 54.

Accordingly, when the R-axis motor 51 is driven, the nozzle shafts 54 holding the plurality of suction nozzles 55 are rotated around a vertical axis (in an R-axis direction) through the index shaft 52. As a result, the plurality of suction nozzles 55 are sequentially indexed to a predetermined angular position (component suction position).

A rotating body 58 on which a driven gear 56 and a θ-axis gear 57 are formed is supported on the index shaft 52 only to be rotatable. A θ-axis motor 59 is fixed to the head body 50, and the driven gear 56 meshes with a driving gear 60 that is rotated by the θ-axis motor 59. The θ-axis gear 57 is formed over a predetermined length along the axial direction of the rotating body 58, and a nozzle gear 61 fixed to the upper end of each nozzle shaft 54 meshes with the θ-axis gear 57 so as to be slidable relative to the θ-axis gear 57.

Accordingly, when the θ-axis motor 59 is driven, all the nozzle shafts 54 are rotated relative to the rotary head 53 through the driving gear 60, the driven gear 56, the θ-axis gear 57, and the nozzle gears 61.

Further, a nozzle actuating member 62 is guided on the head body 50 by a guide bar 63 so as to be slidable in a vertical direction. The nozzle actuating member 62 is adapted so as to be moved up and down by a ball screw mechanism 65 that is actuated by a Z-axis motor 64 fixed to the head body 50. The nozzle actuating member 62 includes a pressing portion 66 that comes into contact with the upper end of the nozzle shaft 54 indexed to the component suction position and presses the nozzle shaft 54 downward in a Z-axis direction.

Accordingly, when the Z-axis motor 64 is driven, the nozzle actuating member 62 is moved in the vertical direction by the ball screw mechanism 65. As a result, the nozzle shaft 54 indexed to the component suction position is moved up and down in the Z-axis direction by the pressing portion 66.

A component camera 68 (see Fig. 1) taking an image of an electronic component, which is sucked by the suction nozzle 55, from below is fixed to the base 11. The component camera 68 takes an image of the electronic component sucked by the suction nozzle 55 while the electronic component is moved to a predetermined position on the circuit board B from the component supply position of the component supply device 20; detects a deviation of the center of the electronic component relative to the center of the suction nozzle 55, an angular deviation of the electronic component, and the like; corrects the moving distance of the mounting head 47 in the XY direction on the basis of the deviation of the center of the electronic component, and the like; and corrects an angle by the rotation of the suction nozzle 55. Accordingly, the component camera 68 allows the electronic component to be accurately mounted at a coordinate position determined on the circuit board B.

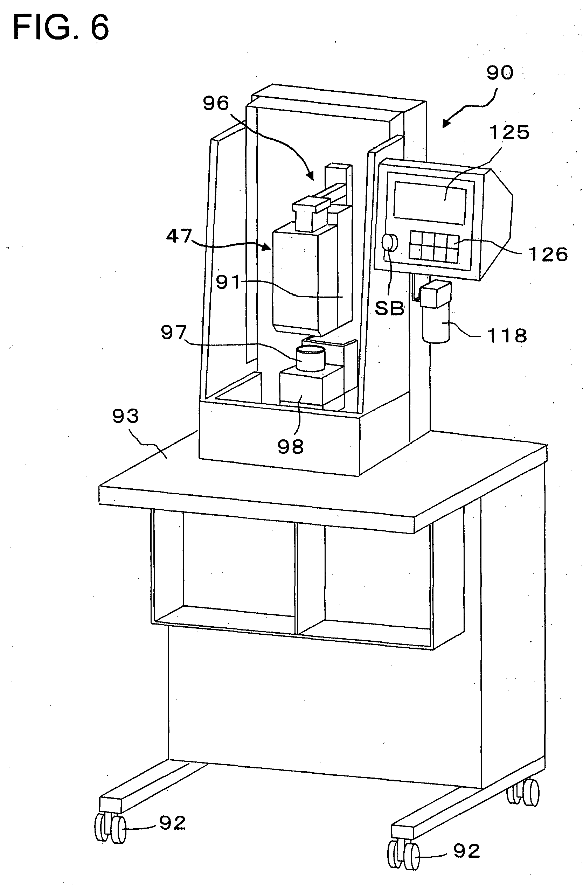

Plural kinds of mounting heads 47 having the above-mentioned structure are prepared according to the kinds of the circuit board B or the like. These mounting heads 47 are detachably mounted on the X-axis slide 45. Accordingly, the mounting heads 47 are separated from the X-axis slide 45 and mounted on a cleaning unit 90 to be described below (see Fig. 6) when being cleaned or checked.

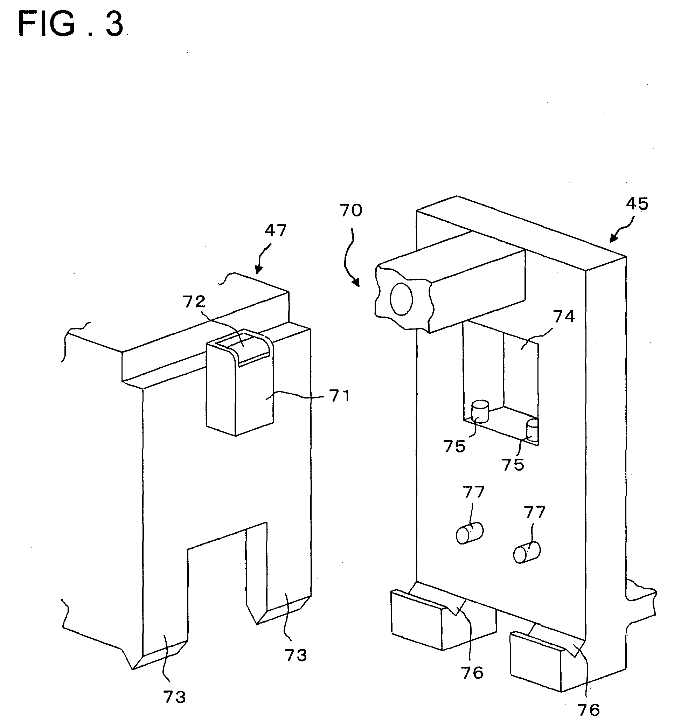

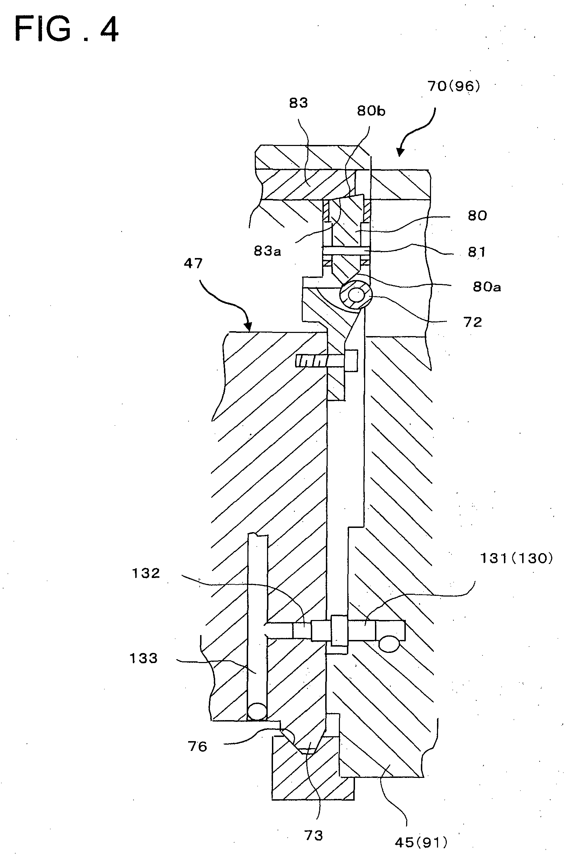

The structure of a head clamping device 70, which clamps the mounting head 47 on the X-axis slide 45, will be described below with reference to Figs. 3 and 4.

In Fig. 3, the mounting head 47 is detachably mounted on the front surface of the X-axis slide 45. That is, an engaging block 71 is provided at an upper portion of the back surface of the mounting head 47, which is to be mounted on the front surface of the X-axis slide 45, and an engaging roller 72 is supported by the engaging block 71 so as to be rotatable about an axis parallel to the X-axis direction. Further, two legs 73 having a V-shaped cross-section are formed at positions, which are spaced apart from each other in the X-axis direction by a predetermined distance, on a lower portion of the back surface of the mounting head 47 so as to be spaced apart from each other in the X-axis direction by the predetermined distance.

Meanwhile, a receiving hole 74, which receives the engaging block 71, is formed at an upper portion of the front surface of the X-axis slide 45, and a pair of upper positioning rollers 75, which are to be engaged with both sides of the engaging block 71, are formed in the receiving hole 74 so as to be spaced apart from each other in the X-axis direction. Further, two leg supporting portions 76, which are to be engaged with the two legs 73 and have the shape of a V-shaped groove, are formed at a lower portion of the front surface of the X-axis slide 45, and a pair of lower positioning rollers 77 are formed above the leg supporting portions 76 so as to be spaced apart from each other in the X-axis direction. The pair of lower positioning rollers 77 are engaged with inner end faces of the two legs 73 of the mounting head 47.

Accordingly, the movement of the mounting head 47 relative to the X-axis slide 45 in the Z-axis direction is regulated by the engagement between the two legs 73 and the two leg supporting portions 76. Moreover, since the pair of upper positioning rollers 75 are engaged with the both sides of the engaging block 71 and the pair of lower positioning rollers 77 are engaged with the inner end faces of the two legs 73, the movement of the mounting head 47 relative to the X-axis slide 45 in the X-axis direction is regulated. In this state, the back surface of the mounting head 47 can come into surface contact with the front surface of the X-axis slide 45.

A pusher member 80 is supported at an upper portion of the X-axis slide 45 so as to be slidable in the vertical direction as shown in Fig. 4, and the rotation of the pusher member 80 is regulated by a pin 81. An inclined surface 80a, which is to be engaged with the engaging roller 72 supported by the mounting head 47, is formed at the tip (lower end) of the pusher member 80. The inclined surface 80a of the pusher member 80 acts to make the back surface of the mounting head 47 come into pressure contact with the front surface of the X-axis slide 45 by being engaged with the engaging roller 72. A wedge face 80b is formed at the upper end of the pusher member 80, and a wedge face 83a of a pressing member 83 is engaged with the wedge face 80b. The pressing member 83 is moved in an axial direction by the operation of an operation member (not shown), and presses down the pusher member 80 through both the wedge faces 83a and 80b.

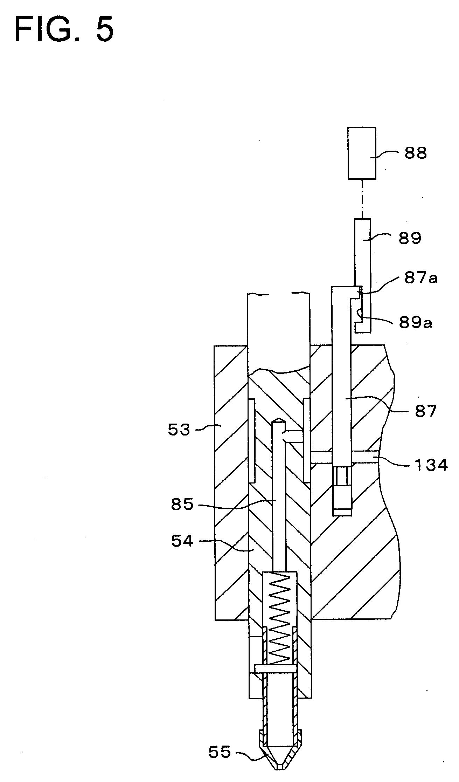

Further, the mounting head 47 is provided with a connection pipe line 132 that communicates with negative-pressure air passages 85 (see Fig. 5) formed at the central portions of the nozzle shafts 54 through communication passages 134 (see Fig. 5) and air introduction passages 133. The connection pipe line 132 is connected to a supply pipe line 131, which is provided in the X-axis slide 45, when the mounting head 47 is mounted on the X-axis slide 45.

As shown in Fig. 5, the suction nozzle 55 is adapted to suck an electronic component when negative-pressure air is supplied to the negative-pressure air passage 85 formed at the central portion of the nozzle shaft 54, and is adapted to release the electronic component when the supply of negative-pressure air is stopped and positive pressure is supplied. The switching between the supply and cut-off of negative-pressure air to the negative-pressure air passage 85 is performed by a mechanical switching valve (hereinafter, referred to as a mechanical valve) 87 that is provided on each of the nozzle shafts 54.

The mechanical valves 87 of which the number (N) is the same as the number of suction nozzles 55 are fitted to the rotary head 53 so as to be slidable in the vertical direction. The upper ends of the respective mechanical valves 87 protrude from the upper surface of the rotary head 53, and engaging portions 87a are formed at these protruding portions of the mechanical valves. The engaging portion 87a of the mechanical valve 87 can be detachably engaged with an engaging portion 89a of an actuating shaft 89 that is moved up and down by a predetermined distance by a stepping motor 88. Accordingly, the engaging portions 87a of the mechanical valves 87 are sequentially engaged with the engaging portion 89a of the actuating shaft 89 by the indexing of the rotary head 53.

Meanwhile, the sliding of the mechanical valve 87 caused by gravity or the like is prevented by a frictional force maintaining device (not shown). Accordingly, as long as a large force exceeding a frictional force is not applied to the mechanical valve 87, the mechanical valve 87 is held at an upper end position or a lower end position.

When the mechanical valve 87, which corresponds to the suction nozzle 55 indexed to the component suction position, is disengaged from the actuating shaft 89 by the rotation (R-axis rotation) of the rotary head 53 and the rotary head 53 is indexed by a predetermined angle, the mechanical valve 87 corresponding to the adjacent suction nozzle 55 is engaged with the actuating shaft 89. Further, when the actuating shaft 89 is moved up and down by the stepping motor 88, the mechanical valve 87 is moved between the upper end position and the lower end position.

When the mechanical valve 87 is moved to the upper end position from a position shown in Fig. 5, the mechanical valve 87 is operated so as to be turned on and air supplied into the mounting head 47 can be introduced into the negative-pressure air passage 85. In contrast, when the mechanical valve 87 is moved to the lower end position, the mechanical valve 87 is operated so as to be turned off and the introduction of air, which has been supplied into the mounting head 47, into the negative-pressure air passage 85 can be cut off.

Fig. 6 is a perspective view showing the entire cleaning unit 90 that cleans the negative-pressure air passages 85 of the mounting head 47. Since the cleaning unit 90 is installed on a working table 93 with casters 92, the cleaning unit 90 can be moved to an arbitrary position together with the working table 93. The mounting head 47 including the rotary head 53 (see Fig. 2) is appropriately mounted on the cleaning unit 90, and is covered with a cover (not shown) that can be opened and closed and is made of a resin or the like having a certain degree of transparency. An operation panel 95 is mounted on the cleaning unit 90, the operation panel 95 is provided with a display unit (monitor) 125 and a keyboard 126 for the input of data, and the keyboard 126 is provided with various operation buttons, such as a start button SB, an arrow key 128 that is used to move a cursor displayed on the display unit 125, and the like.

The display unit 125 is adapted to display a selection mode, which is used to select whether the mounting head 47 mounted on the cleaning unit 90 is cleaned or checked, the results after cleaning, and the like.

A head clamping device 96 is provided at a portion of the cleaning unit 90 where the mounting head 47 separated from the component mounting machine 10 is to be mounted, and the mounting head 47 is positioned and clamped on a unit body 91 of the cleaning unit 90 by the head clamping device 96. Further, the cleaning unit 90 is provided with an oil recovery box 98 that includes a dirt suction blower 97 sucking air or oil having cleaned the inside of the mounting head 47.

Meanwhile, the head clamping device 96 is common to (has the same structure as) the head clamping device 70 (see Fig. 4) that clamps the mounting head 47 on the X-axis slide 45 of the component mounting machine 10, and Fig. 4 shows a state in which the mounting head 47 is mounted (positioned and clamped) on the unit body 91 of the cleaning unit 90. Further, when the mounting head 47 is to be cleaned, the mounting head 47 is separated from the component mounting machine 10, is transported to the cleaning unit 90, and is mounted on the unit body 91 of the cleaning unit 90 by the head clamping device 96.

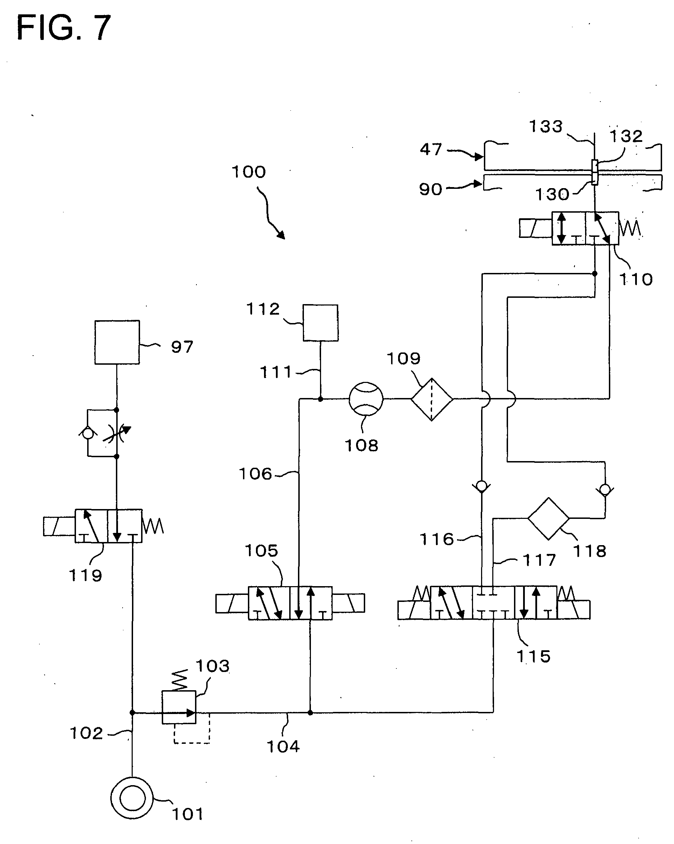

Fig. 7 is a view showing a fluid supply circuit 100 that is provided in the cleaning unit 90. The fluid supply circuit 100 includes an air supply passage 102 that is connected to an air supply source (compressor) 101, and a main passage 104 on which a regulator valve 103 is disposed is connected to the air supply passage 102.

The main passage 104 is adapted to be selectively connected to an air passage 116 for cleaning and an oil passage 117 for cleaning through an air/oil cleaning switching valve 115. The air passage 116 for cleaning and the oil passage 117 for cleaning are connected to each other in front of a cleaning/checking path switching valve 110, and are connected to an input port of the cleaning/checking path switching valve 110.

A lubricator 118 (see Fig. 6) is disposed on the oil passage 117 for cleaning, and the main passage 104 and the oil passage 117 for cleaning are connected to each other by the switching of the air/oil cleaning switching valve 115. When air is supplied to the oil passage 117 for cleaning, oil is changed into the form of mist by the lubricator 118 and is sent to the input port of the cleaning/checking path switching valve 110.

Meanwhile, for example, a mixture, which is obtained by mixing volatile solvent to fluorine oil, is used as the oil. In contrast, when the main passage 104 and the air passage 116 for cleaning are connected to each other by the switching of the air/oil cleaning switching valve 115, air is sent to the input port of the cleaning/checking path switching valve 110.

On the other hand, the main passage 104 is connected to an air passage 106 for checking through a valve 105 for checking that is disposed in parallel with the air/oil cleaning switching valve 115. A flow rate measuring sensor 108 and a filter 109 are disposed in the air passage 106 for checking from the upstream side, and air having passed through the filter 109 is sent to the input port of the cleaning/checking path switching valve 110. Further, a vacuum pressure measuring sensor 112, which measures the pressure of air flowing in the air passage 106 for checking, is connected to a branch passage 111 that is branched from the air passage 106 for checking. The flow rate measuring sensor 108 and the vacuum pressure measuring sensor 112 form air measuring means.

Further, checking air, which is supplied through the air passage 106 for checking, or air or oil (oil mist), which is selectively supplied through the air passage 116 for cleaning or the oil passage 117 for cleaning, is supplied to a supply pipe line 130, which is provided in the unit body 91, through the cleaning/checking path switching valve 110 by the switching of the air/oil cleaning switching valve 115 and the valve 105 for checking.

The valve 105 for checking and the air/oil cleaning switching valve 115, which have been described above, form switching means for selectively supplying air, which is supplied from the air supply source 101, to the passages 116 and 117 for cleaning or the air passage 106 for checking.

Furthermore, the dirt suction blower 97 (see Fig. 6) is connected to the air supply passage 102 through a dirt suction valve 119. The dirt suction valve 119 is switched at the time of cleaning of the mounting head 47, and dirty air or oil, which is discharged from the tip of the suction nozzle 55 of the mounting head 47, is sucked by the dirt suction blower 97. Accordingly, the scattering of the dirty air or oil to the surroundings is prevented.

When the mounting head 47 is positioned and clamped on the unit body 91 of the cleaning unit 90, the supply pipe line 130 provided in the unit body 91 and the connection pipe line 132 provided in the head body 50 of the mounting head 47 are connected to each other and air or oil is supplied to the air introduction passage 133, which is formed in the mounting head 47, from the cleaning unit 90 through the supply pipe line 130 and the connection pipe line 132. The supply pipe line 130, the connection pipe line 132, and the air introduction passage 133 form introducing means for introducing air into each negative-pressure air passage 85 from the air passage 116 for cleaning, the oil passage 117 for cleaning, or the air passage 106 for checking.

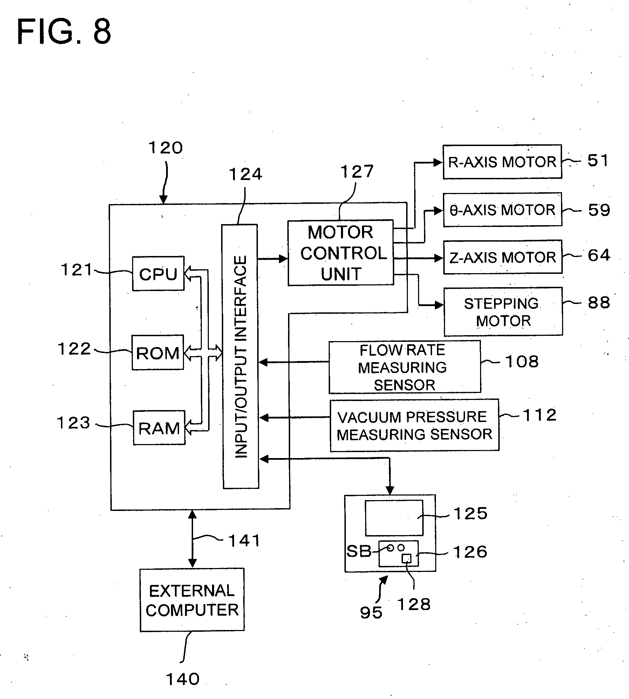

Fig. 8 is a view showing a controller 120 that controls the cleaning unit 90. The controller 120 includes a central processing unit (CPU) 121, memories (a ROM 122 and a RAM 123) that store various control data and control programs, and the like, and an input/output interface 124. The display unit 125 of the above-mentioned operation panel 95 and the like are connected to the input/output interface 124.

Further, a motor control unit 127, which controls the R-axis motor 51, the θ-axis motor 59, the Z-axis motor 64, and the stepping motor 88 of the mounting head 47 mounted on the cleaning unit 90, is connected to the input/output interface 124. Furthermore, the flow rate measuring sensor 108 and the vacuum pressure measuring sensor 112 of the fluid supply circuit 100 are connected to the input/output interface 124. A cleaning cycle or a checking cycle of the mounting head 47, which is mounted on the cleaning unit 90, is performed by the controller 120.

The display unit 125 of the operation panel 95 displays a serial number of the mounting head 47 mounted on the cleaning unit 90, date and time at which cleaning or checking is performed, various check results, the result of the determination of whether the mounting head 47 is acceptable or not, which is based on the check results, and the like. These displayed contents are stored in the RAM 123 of the controller 120. Since an external computer 140 is connected to the controller 120 through a LAN cable 141, data, such as the date and time at which cleaning is performed and the check results, are transmitted to the external computer 140 through the LAN cable 141 and can be stored in the external computer 140. Accordingly, it is possible to read the history of cleaning and checking and to inform a user of the next cleaning time and the like by the external computer 140.

Next, an operation for cleaning or checking the mounting head 47 will be described. When the mounting head 47 is to be cleaned or checked, the mounting head 47 is separated from the X-axis slide 45 of the component mounting machine 10 and is mounted on the unit body 91 of the cleaning unit 90. The mounting of the mounting head 47 on the cleaning unit 90 is performed in the same manner as a case in which the mounting head 47 is mounted on the component mounting machine 10.

Specifically, while the legs 73 of the mounting head 47 are engaged with the leg supporting portions (76) of the unit body 91 and the engaging block 71 and the legs 73 of the mounting head 47 are engaged with the upper and lower positioning rollers (75 and 77) of the unit body 91, the back surface of the mounting head 47 is made to approach the surface of the unit body 91. Accordingly, the pusher member (80), which is in a free state, is moved up by the engaging roller 72, the engaging roller 72 goes over the pusher member (80), and the back surface of the head body 50 of the mounting head 47 comes into contact with the surface of the unit body 91.

Accordingly, the supply pipe line 130 of the cleaning unit 90 and the connection pipe line 132 of the mounting head 47 are connected to each other, so that air and oil mist can be supplied to the air introduction passage 133, which is formed in the mounting head 47, from the air supply source 101 of the cleaning unit 90.

When the operation member (not shown) is operated in this state, the pusher member (80) is pressed down by a wedge action, the pusher member (80) is engaged with the engaging roller 72, and the back surface of the mounting head 47 comes into pressure contact with the surface of the unit body 91 of the cleaning unit 90. Accordingly, the mounting head 47 is positioned and clamped on the cleaning unit 90. After that, electrical systems and communication systems of the cleaning unit 90 and the mounting head 47 are connected to each other by a connector, and preliminary preparation for cleaning/checking is completed.

When the mounting head 47 is mounted on the cleaning unit 90 in this way and the cover (not shown) is closed, the operation panel 95 displays the serial number of the mounting head 47 and displays a selection screen used to select whether to perform a cleaning mode or a checking mode. Here, for example, when the cleaning mode is selected, a selection screen used to select whether to perform cleaning using air or cleaning using oil (for example, oil mist including fluorine oil) is then displayed. When cleaning using air is selected and the start button SB provided on the operation panel 95 is operated, a cleaning cycle using air is performed.

Meanwhile, since cleaning using air is simpler than cleaning using oil, it is preferable that cleaning using air be performed, for example, every month, cleaning using oil functioning as lubrication be performed, for example, every three months, and a checking mode be performed as necessary. Accordingly, it is possible to effectively clean and check the mounting head 47 without wasting any time.

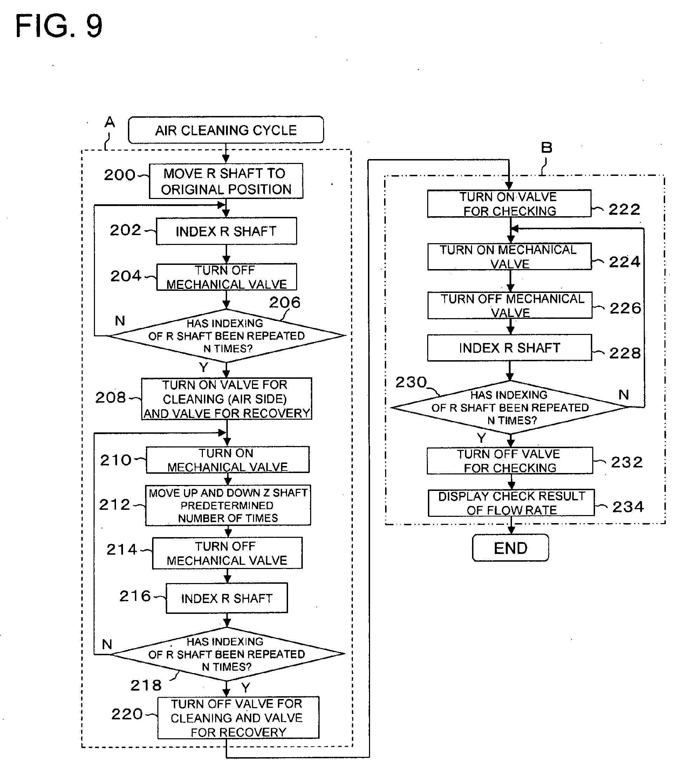

When cleaning using air is selected, an air cleaning cycle shown in the flow of Fig. 9 is performed. That is, in Step 200, the rotary head (R shaft) 53 is moved to an original position by the R-axis motor 51. After that, in Step 202, the R shaft is indexed by a predetermined angle (360/N degrees if the number of suction nozzles 55 is N). In a subsequent step 204, the mechanical valve 87 corresponding to each suction nozzle 55 is operated by the stepping motor 88 so as to be turned off (a state shown in Fig. 5). Accordingly, the negative-pressure air passage 85 is closed.

Next, in Step 206, it is determined whether or not the indexing of the R shaft has been repeated N times. If it is determined that the number of repetition times of the indexing of the R shaft is smaller than N, the processing of Steps 202 to 206 is repeated. If it is determined in Step 206 that the indexing of the R shaft has been repeated N times, processing proceeds to Step 208, which will be described below. All the mechanical valves 87 corresponding to the respective suction nozzles 55 are operated so as to be turned off by this processing, and all the negative-pressure air passages 85 communicating with the respective suction nozzles 55 are reset to a closed state.

After that, in Step 208, the air/oil cleaning switching valve 115 is switched to the right side in Fig. 7 (to the air passage 116 for cleaning), the cleaning/checking path switching valve 110 is switched to the right side in Fig. 7, and the dirt suction valve 119 is switched to the right side in Fig. 7 at the same time. Accordingly, air, which has been supplied to the air supply passage 102 from the air supply source 101, is supplied to the supply pipe line 130 of the cleaning unit 90 through the air/oil cleaning switching valve 115, the air passage 116 for cleaning, and the cleaning/checking path switching valve 110; and air is introduced into the air introduction passage 133, which is formed in the mounting head 47, through the connection pipe line 132 of the mounting head 47. At the same time, air supplied to the air supply passage 102 is supplied to the dirt suction blower 97 through the dirt suction valve 119 and the dirt suction blower 97 is actuated.

Subsequently, in Step 210, the mechanical valve 87 corresponding to the first suction nozzle 55, which is indexed to the component suction position, is moved up by the stepping motor 88 and is operated so as to be turned on, and the negative-pressure air passage 85 communicating with the first suction nozzle 55 is opened. Accordingly, air, which has been introduced into the air introduction passage 133 formed in the mounting head 47, is supplied to the negative-pressure air passage 85, which communicates with the first suction nozzle 55, through the communication passage 134, and is ejected from the tip of the suction nozzle 55.

Cleaning air, which has been introduced into the negative-pressure air passage 85, is also supplied to the nozzle shaft 54 and a sliding portion of the mechanical valve 87, so that dust and the like sucked into the negative-pressure air passage 85 through the suction of the electronic component are excluded from the mounting head 47. Accordingly, dirt on the nozzle shaft 54 and the mechanical valve 87 is washed off. Air, which has been ejected from the tip of the suction nozzle 55, is sucked by the dirt suction blower 97, so that the scattering of the air is prevented.

After that, in Step 212, the nozzle shaft 54, which holds the first suction nozzle 55, is moved up and down in the Z-axis direction a predetermined number of times by the nozzle actuating member 62 that is moved up and down by the Z-axis motor 64. Accordingly, dust or metal powder, which is generated by the sliding of the nozzle shaft 54, is effectively excluded from the sliding portion of the nozzle shaft 54 (a portion of the nozzle shaft fitted to the rotary head 53) by air, so that dirt on the nozzle shaft 54 is washed off. After that, in Step 214, the mechanical valve 87 corresponding to the first suction nozzle 55 is operated so as to be turned off again and the negative-pressure air passage 85 is closed.

Next, in Step 216, the R shaft (rotary head 53) is indexed by a predetermined angle (360/N degrees). In a subsequent step 218, it is determined whether or not the indexing of the R shaft has been repeated N times. If it is determined that the number of repetition times of the indexing of the R shaft is smaller than N, the processing of Steps 210 to 218 is repeated, the negative-pressure air passages 85 communicating with the second and third suction nozzles 55 are opened, and the respective negative-pressure air passages 85 are sequentially cleaned.

Further, if it is determined in Step 218 that the indexing of the R shaft has been repeated N times, that is, if the cleaning of the negative-pressure air passage 85, the nozzle shaft 54, and the mechanical valve 87 communicating with the final (N-th) suction nozzle 55 is ended, processing proceeds to Step 220, the air/oil cleaning switching valve 115, the cleaning/checking path switching valve 110, and the dirt suction valve 119 are switched to the original positions shown in Fig. 7, and the supply of air to the mounting head 47 is stopped.

Subsequently, in Step 222, the valve 105 for checking is switched to the right side in Fig. 7 and air, which has been supplied to the air supply passage 102 from the air supply source 101, is supplied to the air passage 106 for checking through the valve 105 for checking. After passing through the flow rate measuring sensor 108, air, which has been supplied to the air passage 106 for checking, is supplied to the supply pipe line 130 of the cleaning unit 90 through the cleaning/checking path switching valve 110 and is introduced into the air introduction passage 133, which is formed in the mounting head 47, through the connection pipe line 132 of the mounting head 47.

Subsequently, in Step 224, the mechanical valve 87 is operated so as to be turned on and air, which has been introduced to the air introduction passage 133, is supplied to the negative-pressure air passage 85 through the communication passage 134 by the turn-on operation of the mechanical valve 87 and is discharged to the outside from the suction nozzle 55.

In this case, the flow rate of air, which flows in the air passage 106 for checking, is measured by the flow rate measuring sensor 108 and information about the measured flow rate is stored in the RAM 123 of the controller 120. The information about the flow rate, which has been stored in the RAM 123, is compared with a threshold that is registered in the ROM 122 in advance. If the measured flow rate exceeds the threshold, that is, if dust and the like are excluded as a result of the cleaning of the inside of the mounting head 47 and air sufficiently flows, it is determined that cleaning using air is performed well and it is determined that the mounting head 47 is acceptable.

After that, in Step 226, the mechanical valve 87 is operated so as to be turned off. Next, in Step 228, the R shaft is indexed by a predetermined angle (360/N degrees). In a subsequent step 230, it is determined whether or not the indexing of the R shaft has been repeated N times. If it is determined that the number of repetition times of the indexing of the R shaft is smaller than N, the processing of Steps 224 to 230 is repeated. If it is determined in Step 230 that the indexing of the R shaft has been repeated N times, processing proceeds to Step 232 and the valve 105 for checking is switched to the original position. Next, in Step 234, the operation panel 95 displays the check result of the flow rate measured by the flow rate measuring sensor 108 and the result of the determination of whether the mounting head 47 is acceptable or not, and a cleaning cycle using air is ended.

After that, the mounting head 47, which has been cleaned, is separated from the cleaning unit 90. When another mounting head 47 is to be cleaned, the mounting head 47 is mounted on the cleaning unit 90 in the same procedure as described above. When cleaning using air is to be performed, the above-mentioned cleaning cycle is started only by pressing the start button SB.

Meanwhile, when another cycle (cleaning using oil or checking) is to be performed, a selected cycle is performed by selecting a selection screen that is displayed on the operation panel 95.

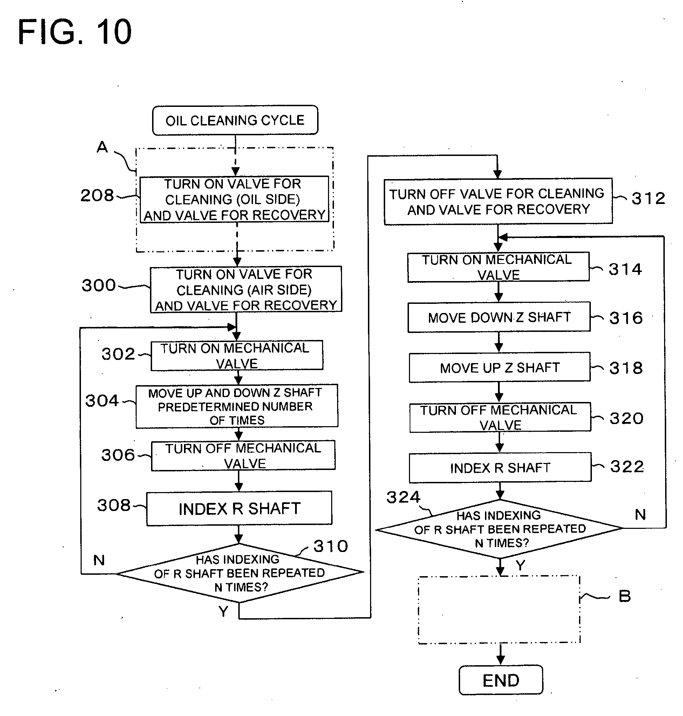

Fig. 10 is a view illustrating the flow of cleaning using oil. The cleaning using oil is different from the above-mentioned cleaning using air in that the air/oil cleaning switching valve 115 is switched to the left side in Fig. 7 (to the oil passage 117 for cleaning) in Step 208 of the processing (Steps 200 to 220) of A of Fig. 9 in contrast to the above description, operations of Steps 302 to 324 are added after Step 220, and processing (Steps 222 to 234) of B of Fig. 9 is then performed.

Since the air/oil cleaning switching valve 115 is switched to the left side in Fig. 7, air supplied to the main passage 104 is sent to the oil passage 117 for cleaning and oil (fluorine oil) is changed into the form of mist by the lubricator 118 and sent into the mounting head 47. Accordingly, the negative-pressure air passage 85 can be cleaned by oil mist. Meanwhile, since other kinds of processing are the same as described above, the description thereof will be omitted.

If oil (oil mist) is supplied into the negative-pressure air passage 85, oil adheres to the inside of the negative-pressure air passage 85 and remains in the negative-pressure air passage 85 or permeates the nozzle shaft 54 and the sliding portion of the mechanical valve 87. Accordingly, the additional steps 302 to 324 are to blow off oil, which remains in the mounting head 47, by supplying air to the negative-pressure air passage 85 after the cleaning using oil and to lubricate the nozzle shaft 54 and the sliding portion of the mechanical valve 87 with remaining oil by performing an idling operation for a predetermined time (for example, about 30 seconds) after that. Accordingly, the additional steps 302 to 324 will be mainly described below.

As shown in Fig. 9, when the air/oil cleaning switching valve 115 is switched to the left side in Fig. 7 (to the oil passage 117 for cleaning) in Step 208 and the mechanical valve 87 is operated so as to be turned on in Step 210, air supplied to the main passage 104 is sent to the oil passage 117 for cleaning and oil (fluorine oil) is changed into the form of mist by the lubricator 118 and sent into the mounting head 47. Accordingly, the negative-pressure air passage 85 communicating with the first suction nozzle 55 is cleaned by oil mist.

When the cleaning using oil for the negative-pressure air passage 85, which communicates with the final suction nozzle 55, is ended and the processing of A of Fig. 9 is completed in this way, the air/oil cleaning switching valve 115 is switched to the air passage 116 for cleaning, the dirt suction valve 119 is switched, and the dirt suction blower 97 is actuated in Step 300. After that, the mechanical valve 87 is operated so as to be turned on in Step 302 and the nozzle shaft 54 holding the first suction nozzle 55 is moved up and down in the Z-axis direction a predetermined number of times by the Z-axis motor 64 in Step 304.

Accordingly, air is supplied to the negative-pressure air passage 85 communicating with the first suction nozzle 55; and oil, which adheres to the negative-pressure air passage 85, the nozzle shaft 54, and the sliding portion of the mechanical valve 87, is blown off by the cleaning using oil, is ejected from the tip of the suction nozzle 55, and is sucked by the dirt suction blower 97. After that, in Step 306, the mechanical valve 87 corresponding to the first suction nozzle 55 is operated so as to be turned off and the negative-pressure air passage 85 is closed.

Next, the R shaft is indexed by a predetermined angle (360/N degrees) in Step 308. In a subsequent step 310, it is determined whether or not the indexing of the R shaft has been repeated N times. If it is determined that the number of repetition times of the indexing of the R shaft is smaller than N, the processing of Steps 302 to 310 is repeated. If it is determined in Step 310 that the indexing of the R shaft has been repeated N times, processing proceeds to Step 312 and the air/oil cleaning switching valve 115 and the dirt suction valve 119 are switched to the original positions shown in Fig. 7.

Subsequently, in Step 314, the mechanical valve 87 corresponding to the first suction nozzle 55 is operated so as to be turned on again. After that, in Steps 316 and 318, the nozzle shaft 54 holding the suction nozzle 55 is moved down and up by the Z-axis motor 64 and performs an idling operation. Accordingly, the sliding portion of the nozzle shaft 54 is effectively lubricated with oil. After that, in Step 320, the mechanical valve 87 is operated so as to be turned off.

Next, in Step 322, the R shaft is indexed by a predetermined angle and the next suction nozzle 55 is indexed to the component suction position. Further, in a subsequent step 324, it is determined whether or not the indexing of the R shaft has been repeated N times. If it is determined that the number of repetition times of the indexing of the R shaft is smaller than N, the processing of Steps 314 to 324 is repeated. If it is determined in Step 324 that the indexing of the R shaft has been repeated N times, processing (Steps 222 to 234) of B of Fig. 9 is performed, the check of the flow rate of air after the cleaning using oil is performed, the operation panel 95 displays the check result of the flow rate measured by the flow rate measuring sensor 108 and the result of the determination is acceptable or not, and a cleaning cycle using oil is ended.

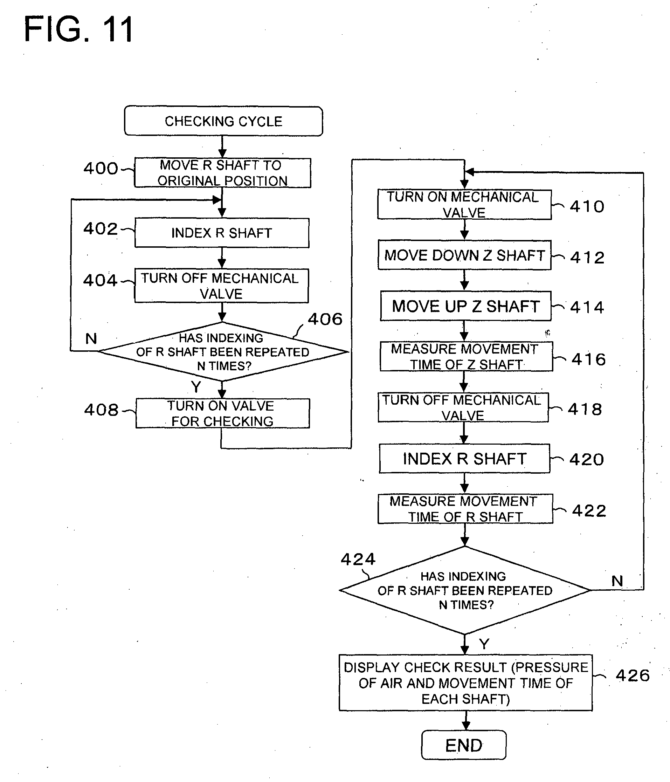

Next, a checking cycle using a checking mode, which checks the performance of the mounting head 47 after the inside of the mounting head 47 is cleaned by air or oil, will be described with reference to a flow of Fig. 11. When the checking mode is to be performed, lids 135 (see Fig. 2) are provided at the tips of all the suction nozzles 55 so that air is not ejected from the tips of the suction nozzles 55. For this purpose, the mounting head 47 is temporarily separated from the cleaning unit 90. Further, when the mounting head 47 is separated, the tips of the suction nozzles 55 are covered with the lids 135. After that, the mounting head 47 is mounted on the cleaning unit 90 again.

When the mounting head 47 is mounted on the cleaning unit 90, the operation panel 95 displays a serial number of the mounting head 47 and a selection screen that is used to select whether a mode to be performed is a cleaning mode or a checking mode. Here, when the checking mode is selected and the start button SB is operated, the checking mode is performed. That is, the checking cycle illustrated in the flow of Fig. 11 is performed.

In Fig. 11, all the mechanical valves 87 corresponding to the respective suction nozzles 55 are operated so as to be turned off by Steps 400 to 406 in the same manner as described in Steps 200 to 206 of Fig. 9 and all the negative-pressure air passages 85 communicating with the respective suction nozzles 55 are reset to a closed state.

After that, in Step 408, the valve 105 for checking is switched to the right side in Fig. 7. Accordingly, air, which has been supplied to the air supply passage 102 from the air supply source 101, is supplied to the air passage 106 for checking through the valve 105 for checking. Air, which has been supplied to the air passage 106 for checking, is supplied to the air introduction passage 133 from the supply pipe line 130 of the cleaning unit 90 through the connection pipe line 132 of the mounting head 47.

Subsequently, in Step 410, the mechanical valve 87 is operated so as to be turned on and the negative-pressure air passage 85 communicating with the first suction nozzle 55 indexed to the component suction position is opened. Accordingly, air, which has been introduced into the air introduction passage 133 formed in the mounting head 47, is supplied to the negative-pressure air passage 85, which communicates with the first suction nozzle 55, through the communication passage 134. However, since the suction nozzle 55 is covered with the lid 135 and the ejection of air from the tip of the suction nozzle 55 is prevented, air introduced into the negative-pressure air passage 85 leaks to the outside through the mechanical valve 87, the sliding portion of the nozzle shaft 54, or the like. Pressure in the negative-pressure air passage 85 is changed due to the leakage of air.

Since the vacuum pressure measuring sensor 112 is connected to the air passage 106 for checking that communicates with the negative-pressure air passage 85, the pressure of air present in the negative-pressure air passage 85 is measured by the vacuum pressure measuring sensor 112 and information about the measured pressure of air is stored in the RAM 123 of the controller 120. Further, the information about the pressure of air is compared with the threshold that is registered in the ROM 202 in advance, and it is determined that the information about the pressure of air is normal or abnormal.

After that, in Steps 412 and 414, the Z-axis motor 64 is driven and the nozzle shaft 54 holding the first suction nozzle 55 is moved down and up in the Z-axis direction. Z-axis movement time, which is required for the downward and upward movement of the nozzle shaft 54 moved by the Z-axis motor 64, is measured in a subsequent step 416 and is stored in the RAM 123. Here, the Z-axis movement time depends on the sliding resistance of the nozzle shaft 54. When foreign matters, such as dust, enter, for example, the sliding portion of the nozzle shaft 54, the sliding resistance is increased, so that the Z-axis movement time is lengthened. Further, the Z-axis movement time stored in the RAM 123 is compared with a threshold, which is registered in the ROM 122 in advance, and it is determined whether the Z-axis movement time is acceptable or not.

In a subsequent step 418, the mechanical valve 87 is operated so as to be turned off. After that, in Step 420, the R shaft (rotary head 53) is indexed by a predetermined angle (360/N degrees) by the R-axis motor 51. R-axis movement time of the rotary head 53, which is moved by the R-axis motor 51, is measured in a subsequent step 422 and is stored in the RAM 123. The R-axis movement time, which is stored in the RAM 123, is compared with a threshold, which is registered in the ROM 122 in advance, and it is determined whether the R-axis movement time is acceptable or not.

Next, in Step 424, it is determined whether or not the indexing of the R shaft has been repeated N times. If it is determined that the number of repetition times of the indexing of the R shaft is smaller than N, the processing of Steps 410 to 420 is repeated. If it is determined that the indexing of the R shaft has been repeated N times, in Step 426, the display unit 125 of the operation panel 95 displays the Z-axis movement time, the R-axis movement time, the result of the determination of acceptance, which is based on the movement time, and whether the performance of the mounting head 47 is normal or abnormal, on the basis of the result of the determination.

For example, when the Z-axis movement time of any one of N nozzle shafts 54 deviates from the threshold and it is determined not acceptable, it is determined that the mounting head 47 is abnormal. After the mounting head 47, which is determined as an abnormal mounting head, is separated from the cleaning unit 90, abnormality of the mounting head 47 is dealt with. In this case, since the nozzle shaft 54, which causes the abnormality of the mounting head 47, becomes clear from the check result, it is easy to deal with the abnormality of the mounting head 47. As the check of the performance of the mounting head 47, a θ-axis check may be added in addition to the Z-axis check and the R-axis check.

Meanwhile, if the lids 135 can be mounted on the suction nozzles 55 while the mounting head 47 is mounted on the cleaning unit 90, a checking cycle can continue to be performed without the separation of the mounting head 47 after the cleaning using air or oil. In this case, the R shaft of the rotary head 53 is already moved to the original position, and all the mechanical valves 87 corresponding to the plurality of suction nozzles 55 are kept in an OFF state. Accordingly, the processing of Steps 400 to 406 of the checking cycle can be omitted.

According to the above-mentioned embodiment, the mounting head 47, which has been separated from the component mounting machine 10, is mounted on the head clamping device 96 common to the component mounting machine 10, and air or oil mist is supplied to the negative-pressure air passage 85 formed in the mounting head 47 so that the inside of the mounting head 47 is cleaned. Accordingly, it is possible to simply and efficiently clean the inside of the mounting head.

Further, after the mounting head 47 is mounted on the cleaning unit 90, it is possible to select a cleaning mode, a checking mode, or the like and to easily perform a cleaning cycle or a checking cycle only by operating the operation panel 95 according to the selection screen displayed on the operation panel 95.

Moreover, it is possible to clean the negative-pressure air passage 85 by air or oil introduced into each negative-pressure air passage 85, which is formed in the mounting head 47, from the air passage 116 for cleaning or the oil passage 117 for cleaning of the cleaning unit 90. Accordingly, it is possible to exclude dust and the like that are sucked into the negative-pressure air passage 85 from the suction nozzle 55 at the time of suction of a component and the like,; to display the information about the flow rate, which is measured by the flow rate measuring sensor 108 provided in the air passage 106 for checking, on the operation panel 95 by switching the valve 105 for checking and introducing air into the mounting head 47 from the air passage 106 for checking after cleaning; and to display the result of cleaning, whether the mounting head 47 is acceptable or not, which is based on the result of cleaning, and the like on the operation panel 95.

According to the above-mentioned embodiment, it is possible to selectively perform the cleaning of the negative-pressure air passage 85 with air or oil, and to perform the effective cleaning of the mounting head 47 by, for example, performing cleaning, which uses air, at regular time intervals and performing cleaning using oil per several times of cleaning using air. Further, it is possible to prevent dirty air or oil, which is discharged from the suction nozzle 55 by the cleaning of the negative-pressure air passage 85, from being scattered to the surroundings by the dirt suction blower 97.

Further, according to the above-mentioned embodiment, the discharge of air from the suction nozzle 55 is prevented by the lid 135 at the time of a checking cycle. Accordingly, it is possible to check the leakage or the like of air from the sliding portion of the nozzle shaft 54, which holds the suction nozzle 55 sliding in the rotary head 53, each mechanical switching valve 87, which performs the switching between the supply and cut-off of negative-pressure air to the negative-pressure air passage, or the like by the vacuum pressure measuring sensor 112.

In addition, since it is possible to measure the sliding resistance of the nozzle shaft 54 holding the suction nozzle 55 by measuring the upward and downward movement times of the suction nozzle 55, which is moved up and down by the Z-axis motor 64, at the time of a checking cycle, it is possible to check an abnormal state that is caused by the catching or the like of dust or metal powder at the sliding portion. An example in which the mounting head 47 separated from the component mounting machine 10 is mounted on the cleaning unit 90 by the head clamping device 96 common to the component mounting machine 10 has been described in the above-mentioned embodiment, but the common head clamping device 96 does not need to be necessarily used. An example in which the inside of the mounting head 47 including the rotary head 53, which holds the plurality of suction nozzles 55 and can be indexed, is cleaned has been described in the above-mentioned embodiment. However, the invention can also be applied to the cleaning of the inside of a mounting head 47 that includes a single suction nozzle.

The invention is not limited to the structure described in the above-mentioned embodiment as described above, and may have various modifications without departing from the scope of the invention described in claims.

### Reference Signs List

10: component mounting machine, 47: mounting head, 51: R-axis motor, 53: rotary head, 54: nozzle shaft, 55: suction nozzle, 59: θ-axis motor, 64: Z-axis motor, 85: negative-pressure air passage, 87: mechanical switching valve, 90: cleaning unit, 95: operation panel, 96: head clamping device, 97: dirt suction blower, 100: fluid supply circuit, 101: air supply source, 105: valve for checking, 108, 112: air measuring means (flow rate measuring sensor, vacuum pressure measuring sensor), 110: cleaning/checking path switching valve, 115: air/oil cleaning switching valve, 116: air passage for cleaning, 117: oil passage for cleaning, 118: lubricator, 120: controller, 124: display unit, 130, 132, 133: introducing means (supply pipe line, connection pipe line, air introduction passage), 135: lid

## Claims

1. A mounting head cleaning device comprising:
a mounting head (47) including suction nozzles (55) sucking components, and
a cleaning unit (90) on which the mounting head (47) is detachably mounted and which is configured to clean the inside of the mounting head (47) by supplying air or oil mist to negative-pressure air passages (85) formed in the mounting head (47),
**characterized in that**
the cleaning unit (90) includes
an air supply source (101) for supplying air, a passage (116, 117) for cleaning, and a passage (106) for checking,
switching means (105, 115) for selectively supplying air, which is supplied from the air supply source (101), to the passage (116, 117) for cleaning or the passage (106) for checking,
introducing means (130, 132, 133) for introducing air into the respective negative-pressure air passages (85), which are formed in the mounting head (47) and are connected to the plurality of suction nozzles (55), from the passage (116, 117) for cleaning or the passage (106) for checking that is selected by the switching means (105, 115), and
air measuring means (108, 112) provided in the passage (106) for checking.

2. The mounting head cleaning device according to claim 1,
further comprising an operation panel (95) that displays a result of cleaning on the basis of information measured by the air measuring means (108, 112).

3. The mounting head cleaning device according to claim 1 or 2,
wherein the air measuring means is formed of a flow rate measuring sensor (108) that measures a flow rate of air flowing in the passage (106) for checking.

4. The mounting head cleaning device according to any one of claims 1 to 3,
wherein the passage (116, 117) for cleaning includes
a cleaning air passage (116) that supplies air and a cleaning oil passage (117) that supplies oil mist, and
an air/oil cleaning switching valve (115) for the switching of the cleaning air passage (116) and the cleaning oil passage (117) such that air or oil mist is supplied to the negative-pressure air passages (85).

5. The mounting head cleaning device according to any one of claims 1 to 4,
wherein the cleaning unit (90) includes a dirt suction blower (97) that sucks dirty air or oil discharged from the suction nozzles (55) of the mounting head (47).

6. The mounting head cleaning device according to any one of claims 2 to 5,
further comprising a controller (120) for controlling the cleaning unit (90),
wherein the operation panel (95) displays a selection screen for a cleaning mode used to clean the mounting head (47) and a checking mode used to check the mounting head (47) when the mounting head (47) is mounted on the cleaning unit (90), and
wherein the controller (120) is configured to perform a cleaning cycle or a checking cycle after the selection of the cleaning mode or the checking mode.

7. The mounting head cleaning device according to claim 6,
wherein lids (135) are provided so that air is not discharged from the suction nozzles (55) during the checking cycle.

8. The mounting head cleaning device according to claim 7,
wherein a pressure sensor (112), which measures pressure of air present in the passage (106) for checking, is connected to the passage (106) for checking, and
the operation panel (95) displays the measured pressure of air and a result of determination of whether the mounting head (47) is acceptable or not, which is based on the measured pressure of air during the checking cycle.

9. The mounting head cleaning device according to claim 7,
wherein the mounting head (47) includes a rotary head (53), which holds the plurality of suction nozzles (55) sucking components on the circumference thereof and is capable of being indexed,
wherein the controller (120) is configured to sequentially index the rotary head (53), to move up and down each suction nozzle (55) at each index position, and to measure upward and downward movement times of these suction nozzles (55) during air supply to the negative-pressure air passages (85), and
wherein the operation panel (95) displays the measured upward and downward movement times and a result of determination of whether the mounting head (47) is acceptable or not that is based on the measured upward and downward movement times.

## Patentansprüche

1. Vorrichtung zum Reinigen eines Montage-Kopfes, die umfasst:
einen Montage-Kopf (47), der Ansaugdüsen (55) enthält, die Komponenten ansaugen, und
eine Reinigungs-Einheit (90), an der der Montage-Kopf (47) abnehmbar angebracht wird und die so ausgeführt ist, dass sie das Innere des Montage-Kopfes (47) reinigt, indem sie Unterdruck-Luftkanälen (85) die in dem Montage-Kopf (47) ausgebildet sind, Luft oder Ölnebel zuführt,
**dadurch gekennzeichnet, dass**
die Reinigungs-Einheit (90) enthält:
eine Luft-Zuführquelle (101) mit der einem Kanal (116, 117) zum Reinigen sowie einem Kanal (106) zum Prüfen Luft zugeführt wird,
eine Umschalteinrichtung (105, 115), mit der Luft, die von der Luft-Zuführquelle (101) zugeführt wird, selektiv dem Kanal (116, 117) zum Reinigen oder dem Kanal (106) zum Prüfen zugeführt wird,
eine Einleiteinrichtung (130, 132, 133), mit der Luft von den Kanal (116, 117) zum Reinigen oder dem Kanal (106) zum Prüfen, der durch die Umschalteinrichtung (105, 115) ausgewählt wird, in die entsprechenden Unterdruck-Luftkanäle (85), die in dem Montage-Kopf (47) ausgebildet und mit der Vielzahl von Saugdüsen (55) verbunden sind, eingeleitet wird, und
eine Luft-Messeinrichtung (108, 112), die in dem Kanal (106) zum Prüfen vorhanden ist.

2. Vorrichtung zum Reinigen eines Montage-Kopfes nach Anspruch 1,
die des Weiteren ein Bedienfeld (95) umfasst, das ein Ergebnis der Reinigung auf Basis von durch die Luft-Messeinrichtung (108, 112) gemessenen Informationen anzeigt.

3. Vorrichtung zum Reinigen eines Montage-Kopfes nach Anspruch 1 oder 2,
wobei die Luft-Messeinrichtung aus einem Strömungsgeschwindigkeits-Messsensor (108) besteht, der eine Strömungsgeschwindigkeit von Luft misst, die in dem Kanal (106) zum Prüfen strömt.

4. Vorrichtung zum Reinigen eines Montage-Kopfes nach einem der Ansprüche 1 bis 3, wobei der Kanal (116, 117) zum Reinigen einschließt:
einen Reinigungs-Luftkanal (116) der Luft zuführt, und einen Reinigungs-Ölkanal (117), der Ölnebel zuführt, sowie
ein Luft-/Öl-Reinigungs-Umschaltventil (115), mit dem der Reinigungs-Luftkanal (116) und der Reinigungs-Ölkanal (117) so umgeschaltet werden, dass den unter Druck-Luftkanälen (85) Luft oder Ölnebel zugeführt wird.

5. Vorrichtung zum Reinigen eines Montage-Kopfes nach einem der Ansprüche 1 bis 4,
wobei die Reinigungs-Einheit (90) ein Schmutz-Ansauggebläse (97) enthält, das schmutzige Luft oder schmutziges Öl ansaugt, die/das von den Ansaugdüsen (55) des Montagekopfes (47) zugeführt wird.

6. Vorrichtung zum Reinigen eines Montage-Kopfes nach einem der Ansprüche 2 bis 5,
die des Weiteren eine Steuereinrichtung (120) zum Steuern der Reinigungs-Einheit (90) umfasst,
wobei das Bedienfeld (95) einen Auswahl-Bildschirm für einen Reinigungs-Modus, der zum Reinigen des Montage-Kopfes (47) dient, und einen Prüf-Modus anzeigt, der zum Prüfen des Montage-Kopfes (47) dient, wenn der Montage-Kopf (47) an der Reinigungs-Einheit (90) angebracht wird, und
wobei die Steuereinrichtung (120) so konfiguriert ist, dass sie nach der Auswahl des Reinigungs-Modus oder des Prüf-Modus einen Reinigungs-Zyklus oder einen Prüf-Zyklus durchführt.

7. Vorrichtung zum Reinigen eines Montage-Kopfes nach Anspruch 6,
wobei Klappen (135) vorhanden sind, so dass während des Prüf-Zyklus keine Luft über die Ansaugdüsen (55) ausgestoßen wird.

8. Vorrichtung zum Reinigen eines Montage-Kopfes nach Anspruch 7,
wobei ein Drucksensor (112), der Druck von in dem Kanal (106) zum Prüfen vorhandener Luft misst, mit dem Kanal (106) zum Prüfen verbunden ist, und
das Bedienfeld (95) den gemessenen Druck von Luft und ein Ergebnis von Feststellung dahingehend anzeigt, ob der Montage-Kopf (47) akzeptabel ist oder nicht, das auf den gemessenen Druck von Luft während des Prüf-Zyklus basiert.

9. Vorrichtung zum Reinigen eines Montage-Kopfes nach Anspruch 7,
wobei der Montage-Kopf (47) einen Drehkopf (53) enthält, der die Vielzahl von Ansaugdüsen (55), die Komponenten ansaugen, an seinem Umfang hält und umgeschaltet werden kann,
die Steuereinrichtung (120) so konfiguriert ist, dass sie den Drehkopf (53) sequenziell umschaltet, um jede Ansaugdüse (55) an jeder Umschaltposition nach oben und nach unten zu bewegen, und Häufigkeit von Aufwärts- und Abwärts-Bewegung dieser Ansaugdüsen (55) bei Luftzufuhr zu den Unterdruck-Luftkanälen (85) misst, und
das Bedienfeld (90) die gemessene Häufigkeit von Aufwärts- und Abwärts-Bewegung sowie ein Ergebnis von Feststellung dahingehend anzeigt, ob der Montage-Kopf (47) akzeptabel ist oder nicht, das auf der gemessenen Häufigkeit von Aufwärts- und Abwärts-Bewegung basiert.

## Revendications

1. Dispositif de nettoyage de tête de montage comprenant :
une tête de montage (47) incluant des buses d'aspiration (55) aspirant des composants, et
une unité de nettoyage (90) sur laquelle est montée de manière amovible la tête de montage (47) et qui est configurée pour nettoyer l'intérieur de la tête de montage (47) en fournissant de l'air ou un brouillard d'huile à des passages d'air à pression négative (85) formés dans la tête de montage (47),
**caractérisé en ce que**
l'unité de nettoyage (90) comporte
une source de fourniture d'air (101) pour fournir de l'air, un passage (116, 117) de nettoyage et un passage (106) pour vérification,
un moyen de commutation (105, 115) pour fournir de l'air de façon sélective, qui est fourni par la source de fourniture d'air (101), au passage (116, 117) de nettoyage ou au passage (106) pour vérification,
un moyen d'introduction (130, 132, 133) pour introduire de l'air dans les passages d'air à pression négative respectifs (85), qui sont formés dans la tête de montage (47) et qui sont reliés à la pluralité de buses d'aspiration (55), depuis le passage (116, 117) de nettoyage ou le passage (106) pour vérification qui est sélectionné par le moyen de commutation (105, 115), et
un moyen de mesure d'air (108, 112) prévu dans le passage (106) pour vérification.

2. Dispositif de nettoyage de tête de montage selon la revendication 1,
comprenant en outre un tableau de commande (95) qui affiche le résultat du nettoyage en se fondant sur les informations mesurées par le moyen de mesure d'air (108, 112).

3. Dispositif de nettoyage de tête de montage selon la revendication 1 ou 2,
dans lequel le moyen de mesure d'air est formé d'un capteur de mesure de débit (108) qui mesure le débit de l'air circulant dans le passage (106) pour vérification.

4. Dispositif de nettoyage de tête de montage selon l'une quelconque des revendications 1 à 3,
dans lequel le passage (116, 117) de nettoyage comporte
un passage d'air de nettoyage (116) qui fournit de l'air et un passage d'huile de nettoyage (117) qui fournit un brouillard d'huile, et
un robinet de commutation de nettoyage air/huile (115) pour la commutation du passage d'air de nettoyage (116) et du passage d'huile de nettoyage (117) de sorte que l'air ou le brouillard d'huile est fourni aux passages d'air à pression négative (85).

5. Dispositif de nettoyage de tête de montage selon l'une quelconque des revendications 1 à 4,
dans lequel l'unité de nettoyage (90) comporte un ventilateur aspirant la poussière (97) qui aspire l'air ou l'huile sale évacué des buses d'aspiration (55) de la tête de montage (47).

6. Dispositif de nettoyage de tête de montage selon l'une quelconque des revendications 2 à 5,
comprenant en outre un contrôleur (120) pour commander l'unité de nettoyage (90),
dans lequel le tableau de commande (95) affiche un écran de sélection pour un mode de nettoyage utilisé pour nettoyer la tête de montage (47) et un module de vérification utilisé pour vérifier la tête de montage (47) lorsque la tête de montage (47) est montée sur l'unité de nettoyage (90), et
dans lequel le contrôleur (120) est configuré pour exécuter un cycle de nettoyage ou un cycle de vérification après la sélection du mode de nettoyage ou du mode de vérification.

7. Dispositif de nettoyage de tête de montage selon la revendication 6,
dans lequel des couvercles (135) sont prévus de sorte que l'air n'est pas évacué depuis les buses d'aspiration (55) pendant le cycle de vérification.

8. Dispositif de nettoyage de tête de montage selon la revendication 7,
dans lequel un capteur de pression (112) qui mesure la pression de l'air présent dans le passage (106) pour vérification, est relié au passage (106) pour vérification, et
le tableau de commande (95) affiche la pression d'air mesuré et le résultat de la détermination du fait que la tête de montage (47) est acceptable ou non, qui est fondée sur la pression d'air mesurée pendant le cycle de contrôle.

9. Dispositif de nettoyage de tête de montage selon la revendication 7,
dans lequel la tête de montage (47) comporte une tête rotative (53) qui maintient la pluralité de buses d'aspiration (55) aspirant les composants sur sa circonférence et qui est capable d'être indexée,
dans lequel le contrôleur (120) est configuré pour indexer en séquence la tête rotative (53), pour lever et baisser chaque buse d'aspiration (55) dans chaque position d'index et pour mesurer les temps de mouvement vers le haut et vers le bas de ces buses d'aspiration (55) pendant la fourniture d'air aux passages d'air à pression négative (85), et
dans lequel le tableau de commande (95) affiche les temps des mouvements vers le haut et vers le bas mesurés en conséquence de la détermination du fait que la tête de montage (47) est acceptable ou non, qui est fondée sur les temps de mouvement vers le haut et vers le bas mesurés.
